# EUROPÄISCHE PATENTSCHRIFT

(11) **EP 2 086 059 B1**
(45) Veröffentlichungstag und Bekanntmachung des Hinweises auf die Patenterteilung: **25.08.2010**
(21) Anmeldenummer: 08021137.8
(22) Anmeldetag: 05.12.2008
(51) Int. Cl.: H01R 11/11

(54) **Prüfkabel**
Test cable
Câble de contrôle

(30) Priorität: 29.01.2008 DE 202008001259 U
(43) Veröffentlichungstag der Anmeldung: 05.08.2009
(73) Patentinhaber: SPX Service Solutions Germany GmbH, 85131 Pollenfeld-Preith (DE)
(72) Erfinder: Kapelke, Swen, 86706 Weichering (DE)
(74) Vertreter: Sasse, Volker

(56) Entgegenhaltungen:
- EP-A- 0 893 844
- DE-A1- 2 531 789
- DE-A1- 3 738 099
- DE-A1- 4 109 055
- DE-A1- 4 110 455
- GB-A- 2 203 599

## Beschreibung

Die Erfindung betrifft ein Prüfkabel für mechanisch zu trennende Verbindungsstellen an Kabelbäumen gemäß Anspruch 1.

Aus dem Stand der Technik ist es bei Prüfkabel bekannt, aus dessen Stiftgehäuse von den jeweiligen Lötstellen der einzelnen Litzen ein Zweitkabel wegzuführen, wobei an jeder Lötstelle eine Doppellötung für die abzweigende Litze erforderlich ist. Diese Doppellötstellen sind ein großer Aufwand und bieten keine Gewähr, daß alle Litzen kontaktbündig und fest erfaßt sind. Die vielen Doppellötstellen erfordern außerdem viel Platz, wodurch das Stiftsgehäuse eine unförmige Größe bekommt und sich so auf die Verbindungsstelle für den Kabelbaum stecken läßt. Außerdem müssen die Meßlitzen lang ausgebildet werden, damit sie bis zum Prüfgerät reichen und dort angeschlossen werden können.

Aus der DE 36 36 927 C2 ist eine Zusammenfassung von mehreren Leitungslitzen bekannt, die als Bündel erfaßt werden und kontaktmäßig zusammengeschlossen sind. Diese Zusammenfassung bietet aber nur einen Kontaktpunkt und gibt keine Weisung, wie mehrere nebeneinander liegende Leitungslitzen separat erfaßt, kontaktmäßig zusammengeschlossen und von einer Drittleitung weitergeleitet werden.

Aufgabe der Erfindung ist, die genannten Nachteile zu vermeiden und mit möglichst wenig Aufwand ein elastisches Prüfkabel zu erstellen, von dem günstig und kurz die Meßleitungslitzen abzweigen.

Diese Aufgabe wird durch die kennzeichnenden Merkmale des Anspruchs 1 gelöst. Mit der V-förmigen Ausbildung des Zwischenkabels und der kontaktmäßigen Weiterführung der Meßlitze von dem V-Punkt bleibt das gesamte Prüfkabel sehr elastisch und schlank. Außerdem ist der Herstellungsaufwand sehr gering. Es werden lediglich die getrennten Enden der jeweiligen Zwischenkabellitze zusammengenommen und die weiterführende Meßleitungslitze angefügt und diese drei zusammengeschweißt. Alternativ wird die Leitungslitze an dem V-förmig abgewinkelten Teil abisoliert und mit der weiterführenden Meßleitungslitze aneinandergefügt und zusammengeschweißt. Die Litzen erfahren dabei nur am kurzen Schweißpunkt eine geringfügige Verhärtung, so daß das Prüfkabel auf der gesamten Länge elastisch bleibt. Außerdem erfolgt keine Veränderung an den Kabelsteckern, so daß sich die Prüfkabel genauso gut auf die jeweiligen Steckdosen am zu prüfenden Gerät stecken lassen, wie die Verbindungskabel. Es werden dadurch auch keine Überbeanspruchungen an den Kontakten im Crimpsteckerbereich auftreten.

Es hat sich als besonders vorteilhaft erwiesen, die Merkmale des Anspruchs 2 zu nutzen. Die Ultraschallverschweißung garantiert die vollständige Kontaktnahme der in Y-Form zusammengeführten Litzen. Außerdem ist die Verbindung zug- und kontaktfest. Das entsprechende Anfügen der Meßleitungslitze an die Leitungslitze des Zwischenkabels ist wie eine Verlängerung des gesamten Prüfkabels, obwohl ein geringerer Aufwand an Litzenmaterial erforderlich ist.

Als besonders vorteilhaft haben sich die Merkmale des Anspruchs 3 erwiesen. Durch das Versetzen der einzelnen Schweißpunkte von jeder Leitungslitze mit der Meßleitungslitze entsteht kein zentraler Ballungsraum, an dem das Prüfkabel im Durchmesser dicker ausfällt und dadurch unbeweglich würde. Man erkennt äußerlich nicht, wo die Schweißpunkte sitzen. Dadurch, daß die Schweißpunkte über die Länge des Prüfkabels versetzt sind, ist die Biegsamkeit der Litzen ausreichend gewährt.

Es hat sich als zweckmäßig und auch vorteilhaft erwiesen, die Merkmale des Anspruchs 4 zu nutzen. Die Kontaktlänge der Schweißpunkte einer jeden Leitungslitze mit einer Meßleitungslitze ist sehr gering. Es genügt, diese Kontakte jeweils um ihre Kontaktlänge zu versetzen, um einerseits ein schlankes Kabel zu erhalten und andererseits die geforderte Biegsamkeit für das Kabel zu haben. Je kürzer der Abstand der einzelnen Schweißpunkte voneinander liegenden, desto weniger Litzenmaterial ist erforderlich. Andererseits muß das Prüfkabel eine ausreichende Länge haben, damit es vom zu prüfenden Gerät bis zum Diagnosegerät reicht. Folglich ist für die Versetzung der einzelnen Schweißpunkte genügend Platz.

Eine weitere vorteilhafte Ausgestaltung des Anmeldungsgegenstandes wird mit den Merkmalen des Anspruchs 5 erreicht. Durch die Meßleitung fließt nicht der volle Strom wie durch die Leitungslitzen, sondern es wird nur die entsprechende Spannung gemessen. Folglich können diese Meßleitungslitzen im Durchmesser geringer ausgebildet sein. Das Zusammenfügen von im Durchmesser ungleich starken Litzen ist für die Ultraschallschweißung problemlos. Die dünneren Litzen bieten die gewünschte Biegsamkeit des Kabelbündels. Außerdem ist es preisgünstiger, wenn dünnere Litzen verwendet werden können.

Um das Prüfkabel mit den gebündelten Litzen einfach und günstig zusammenzuhalten, sind die Merkmale des Anspruchs 6 von Vorteil. So ein Gewebe- oder auch Schrumpfschlauch läßt sich sehr einfach über die Litzen schieben, folglich hat man nur einen geringen Aufwand in der Produktion. Die geringfügigen Unebenheiten an den Schweiß stellen werden völlig ausgeglichen. Es ist keine Verseilung der Kabel notwendig. Außerdem machen solche Gewebe- oder Schrumpfschläuche jegliche Biegung mit, sodaß die geforderte Elastizität und Biegsamkeit des Prüfkabels gewährleistet ist. Bei dem Schrumpfschlauch kommt noch hinzu, daß er die Litzen eng zusammenhält und insgesamt als schlankes Kabel erscheint.

Es hat sich für eine kostengünstige und einfache Herstellung des Prüfkabels die Nutzung der Merkmale des Anspruchs 7 erwiesen. Die Crimpverbindungen bieten einen sicheren und guten Kontakt. Ferner ist die Verbindung sehr einfach geschlossen. Da es sich um genaue Meßwerte handelt, ist die eindeutige Kontaktübertragung so wichtig.

Damit die Enden des Gewebeschlauchs sowohl am Stecker wie auch an der V-förmigen Abzweigung fest am Leitungslitzenbündel sitzen und sich nicht verschieben lassen, kommen schließlich die Merkmale des Anspruchs 8 zur Anwendung. Es wird vermieden, daß die einzelnen Litzen freigelegt sind und gegebenenfalls beschädigt werden können. Außerdem ist die V- oder Y-förmige Abzweigstelle fest zusammengehalten, sodaß mechanisch keine Nachteile entstehen können.

Die Erfindung wird nachfolgend unter Bezugnahme auf die Zeichnungen beispielhaft näher beschrieben.

Es zeigen:
- Fig. 1: ein Prüfkabel,
- Fig. 2: versetzte Schweißpunkte von drei nebeneinander liegenden Leitungslit- zen und
- Fig. 3: eine Variante von zusammengeführten Leitungslitzen am Schweißpunkt.

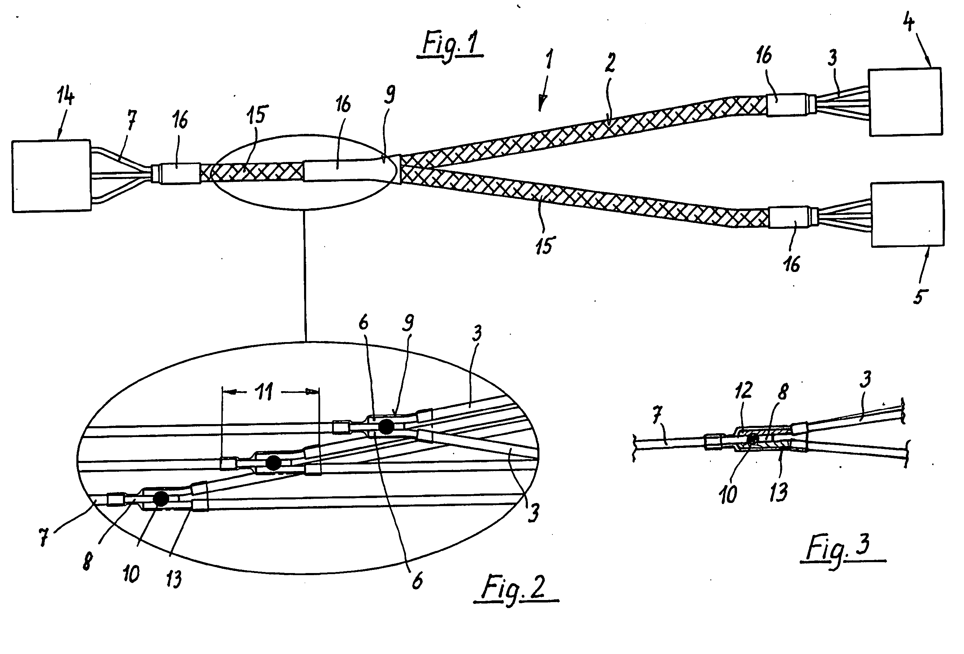

Das in Fig. 1 dargestellte Prüfkabel 1 besteht aus einem Zwischenkabel 2, das von mehreren Leitungslitzen 3 gebildet ist. Die Leitungslitzen 3 sind gebündelt zusammengefaßt und enden auf der einen Seite in einem Buchsengehäuse 4 und am anderen Ende in einem Stiftsgehäuse 5, mit denen sie an das zu prüfende, jedoch nicht dargestellte Gerät gesteckt werden. Auf der halben Länge ist das Zwischenkabel 2 durchtrennt und seine abisolierten Enden 6 einer jeden Leitungslitze 3 sind V-förmig zusammengefaßt, wie es vergrößert in Fig. 2 dargestellt ist. An den abisolierten Enden 6 ist eine weiterführende Meßleitungslitze 7 mit ihrem blanken Ende 8 kontaktmäßig angefügt. Es entsteht ein so genannter V- oder Y-Schnittpunkt 9, an dem die Leitungslitze 3 mit der Meßleitungslitze 7 zusammengefügt und durch Ultraschallschweißung (Induktionsschweißung) kontaktsicher und zugfest festgelegt sind. Der Schweißpunkt ist mit 10 gekennzeichnet.

In Fig. 2 ist der V- oder Y-Schnittpunkt 9 vergrößert dargestellt. Man erkennt, wie die Enden 6 der Leitungslitzen 3 parallel aus gleicher Richtung einlaufen und das Ende 8 der Meßleitungslitze 7 dazwischen gelagert ist, und die Meßleitungslitze 7 in Verlängerung verläuft. Nur die drei Enden 6, 8 der Litzen 3, 7 zusammengefügt sind, erfolgt die Ultraschallverschweißung, die mit dem schwarzen Punkt 10 gekennzeichnet ist. Damit die Schweißpunkte 10 nicht alle nebeneinander liegen und das Prüfkabel 1 an dieser Stelle nicht zu dick und nicht steif ist, sind die Stellen mit den Schweißpunkten 10 über die Länge des Prüfkabels 1 versetzt und zwar jeweils um ungefähr eine Kontaktlänge 11 der Schweißstelle 10. Aus der dargestellten Figur 2 erkennt man, daß die jeweils versetzten Schweißstellen 10 das Prüfkabel 1 in seiner Durchmesserdimension nicht verstärken. Weil der Stromfluß nur durch die Leitungslitzen 3 läuft und über die Meßleitungslitzen 7 im wesentlichen nur die Spannung gemessen wird, können die Meßleitungslitzen 7 im Durchmesser dünner als die Leitungslitzen 3 ausgebildet sein.

Wie aus Fig. 3 hervorgeht, ist die Leitungslitze 3 nicht aufgetrennt, sondern nur über ein kurzes Stück 12 abisoliert und dort V-förmig abgewinkelt. An dieses V-förmige Kurzstück 12 ist ein Ende 8 einer Meßleitungslitze 7 gelegt und dort am Punkt 10 kontaktmäßig zusammengeschweißt. Grundsätzlich werden die Enden 6 der Leitungslitzen 3 mit den Enden 8 der Meßleitungslitzen 7 nur aneinandergelegt und dann im Ultraschweißverfahren jeweils zusammengefügt. Am freien Ende der Meßleitungslitzen 7 ist ein Meßstecker 14 vorgesehen, der die Verbindung zu dem nicht dargestellten Diagnosegerät gibt. Die jeweils verschweißten oder mit einer Crimpverbindung 13 zusammengehaltenen blanken Litzenenden 6, 8 werden einfach mit einem kurzen Stück Schrumpfschlauch 15 überzogen und damit isoliert.

Wie vor allem aus Fig. 1 zu ersehen ist, werden die gebündelten Leitungslitzen 3 wie auch die Meßleitungslitzen 7 von einem übergezogenen Gewebe- oder auch Schrumpfschlauch 15 zusammengehalten. Sowohl an den Enden der Leitungslitzen 3 vor dem Buchsengehäuse 4 und vor dem Stiftsgehäuse 5 als auch an den Enden der Meßleitungslitzen 7 vor dem Meßstecker 14 ist der aufgezogene Gewebe- oder Schrumpfschlauch 15 mit einem Klebeband 16 festgelegt, damit er sich auf den Litzen 3, 7 nicht verschieben kann. Durch diese Isolierung der Litzen wird eine Beschädigung minimiert. Ferner ist auch der V- oder Y-Schnittpunkt mit einem Klebeband 16 umwickelt und abgedeckt und somit geschützt, wobei dieses Klebeband 16 gleichzeitig die dort endenden Gewebe- oder Schrumpfschlauchenden gegen Verschieben festhält.

### Bezugszeichenliste

- 1: Prüfkabel
- 2: Zwischenkabel
- 3: Leitungslitze
- 4: Buchsengehäuse
- 5: Stiftsgehäuse
- 6: abisoliertes Ende
- 7: Meßleitungslitze
- 8: blankes Ende
- 9: V- ohne Y-Schnittpunkt
- 10: Schweißpunkt
- 11: Kontaktlänge
- 12: abgewinkeltes Kurzstück
- 13: Crimpverbindung
- 14: Meßstecker
- 15: Gewebe- oder Schrumpfschlauch
- 16: Klebeband

## Patentansprüche

1. Prüfkabel (1) als Zwischenkabel (2) für mechanisch zu trennende Verbindungsstellen an Kabelbäumen jeglicher Art, bestehend aus mehreren gebündelten isolierten Leitungslitzen (3), wobei von jeder Leitungslitze (3) eine isolierte Meßleitungslitze (7) kontaktmäßig abzweigt und zu einem Bündel zusammengefaßt ist, **dadurch gekennzeichnet, daß** das Zwischenkabel (2) mit seinen isolierten Leitungslitzen (3) auf halber Länge geteilt und ihre abgemantelten Enden (6) jeweils V-förmig zusammengeführt oder auf halber Länge über ein kurzes Stück (12) abisoliert und V-förmig abgewinkelt sind und an dem V Schnittpunkt (9) einer jeden Leitungslitze (3) jeweils die Meßleitungslitze (7) in Verlängerung kontaktmäßig angefügt ist

2. Prüfkabel nach Anspruch 1, **dadurch gekennzeichnet, daß** die Meßleitungslitze (7) mit den beiden Enden (6) der Leitungslitzen (3) des Zwischenkabels (2) in Ultraschallverschweißung (Induktionsschweißung) kontaktmäßig zusammengefügt sind, wobei die beiden Enden (6) der Leitungslitzen (3) des Zwischenkabels (2) von einer Seite und das Ende (8) der Meßleitungslitze (7) von der anderen Seite zu einem Y zusammengefügt sind.

3. Prüfkabel nach Anspruch 1 oder 2, **dadurch gekennzeichnet, daß** die V- oder Y-Schnittpunkte (9) bzw. Schweißstellen (10) einer jeden Leitungslitze (3) mit der jeweils angefügten Meßleitungslitze (7) auf Länge zueinander versetzt sind.

4. Prüfkabel nach mindestens einem der Ansprüche 1 bis 3, **dadurch gekennzeichnet, daß** die kontaktmäßig zusammengefügten Stellen (9) der Leitungslitzen (3) mit den Meßleitungslitzen (7) jeweils um die Kontaktlänge (11) der Schweißstelle (10) auf Reihe versetzt sind.

5. Prüfkabel nach mindestens einem der Ansprüche 1 bis 4, **dadurch gekennzeichnet, daß** die Meßleitungslitze (7) im Durchmesser gleich oder geringer als die Leitungslitzen (3) des Zwischenkabels (2) ausgebildet sind und vorzugsweise höchstens eine 2/3 Litzendurchmesserstärke der Leitungslitze (3) aufweist.

6. Prüfkabel nach mindestens einem der Ansprüche 1 bis 5, **dadurch gekennzeichnet, daß** die jeweils gebündelten, isolierten Leitungslitzen (3) des Zwischenkabels (2) und auch die gebündelten Meßleitungslitzen (7) jeweils von einem Gewebe- oder Schrumpfschlauch (15) zusammen gehalten sind.

7. Prüfkabel nach mindestens einem der Ansprüche 1 bis 6, **dadurch gekennzeichnet, daß** die freien Enden der Leitungslitzen (3) des Zwischenkabels (2) wie auch die der Meßleitungslitzen (7) mit Crimpverbindungen (13) zu den Kontakten festgelegt sind.

8. Prüfkabel nach mindestens einem der Ansprüche 1 bis 7, **dadurch gekennzeichnet, daß** die Enden vom jeweiligen Gewebeschlauch (15) mit einem Klebeband (16) oder einem Schrumpfschlauchstück an den gebündelten Litzen (3, 7) festgelegt sind.

## Claims

1. Test cable (1) as an intermediate cable (2) for connecting points to be mechanically disconnected in cable harnesses of any type, comprising a plurality of bundled insulated line braids (3) wherein an insulated measurement line braid (7) is tapped off, by contact, from each line braid (3) and is combined to a form a bundle, **characterized in that** the intermediate cable (2) with its insulated line braids (3) is split over half the length, and its stripped ends (6) are each combined in a V-shape or are stripped over a short piece (12) over half the length and are angled in a V-shape, and the measurement line braid (7) is in each case attached, making contact, as an extension at the V-intersection point (9) of each line braid (3).

2. Test cable according to Claim 1, **characterized in that** the measurement line braid (7) is joined together, making contact, with the two ends (6) of the line braids (3) of the intermediate cable (2) by ultrasound welding (induction welding), wherein the two ends (6) of the line braids (3) of the intermediate cable (2) on one side, and the end (8) of the measurement line braid (7) on the other side, are joined together to form a Y.

3. Test cable according to Claim 1 or 2, **characterized in that** the V- or Y-intersection points (9) or weld points (10) of each line braid (3) are offset with respect to one another to the correct length, with the respectively attached measurement line braid (7).

4. Test cable according to at least one of Claims 1 to 3, **characterized in that** those points (9) of the line braid (3) which are joined together, making contact, with the measurement line braids (7) are in each case offset in a row by the contact length (11) of the weld point (10).

5. Test cable according to at least one of Claims 1 to 4, **characterized in that** the measurement line braids (7) are formed with a diameter which is less than or equal to that of the line braids (3) of the intermediate cable (2), and preferably has at most 2/3 of the braid diameter thickness of the line braid (3).

6. Test cable according to at least one of Claims 1 to 5, **characterized in that** the respectively bundled, insulated line braids (3) of the intermediate cable (2) as well as the bundled measurement line braids (7) are each held together by a fabric sleeve or shrink sleeve (15).

7. Test cable according to at least one of Claims 1 to 6, **characterized in that** the free ends of the line braids (3) of the intermediate cable (2) as well as those of the measurement line braids (7) are fixed to the contacts by crimp connections (13).

8. Test cable according to at least one of Claims 1 to 7, **characterized in that** the ends of the respective fabric sleeve (15) are fixed to the bundled braids (3, 7) by an adhesive tape (16) or a piece of shrink sleeve.

## Revendications

1. Câble d'essai (1) comme câble intermédiaire (2) pour des points de liaison à séparer mécaniquement sur des faisceaux de câble de toute nature, comprenant plusieurs torons de ligne (3) isolés et regroupés, un toron de ligne de mesure (7) isolé partant au niveau du contact de chaque toron de ligne (3) et étant regroupé pour former un faisceau, **caractérisé en ce que** le câble intermédiaire (2) avec ses torons de ligne (3) isolés est divisé sur la mi-longueur et ses extrémités (6) dénudées sont regroupées à chaque fois en forme de V ou sont dénudées sur la mi-longueur sur un court tronçon (12) et sont coudées en forme de V et à chaque fois le toron de ligne de mesure (7) est ajouté dans le prolongement par contact au point d'intersection en V (9) de chaque toron de ligne (3).

2. Câble d'essai selon la revendication 1, **caractérisé en ce que** le toron de ligne de mesure (7) est assemblé par contact avec les deux extrémités (6) des torons de ligne (3) du câble intermédiaire (2) par soudage aux ultrasons (soudage par induction), les deux extrémités (6) des torons de ligne (3) du câble intermédiaire (2) étant assemblées à partir d'un côté et l'extrémité (8) du toron de ligne de mesure (7) à partir de l'autre côté pour former un Y.

3. Câble d'essai selon la revendication 1 ou 2, **caractérisé en ce que** les points d'intersection en V ou en Y (9) et points de soudure (10) de chaque toron de ligne (3) sont décalés dans la longueur les uns par rapport aux autres avec le toron de ligne de mesure (7) respectivement ajouté.

4. Câble d'essai selon au moins l'une quelconque des revendications 1 à 3, **caractérisé en ce que** les points (9), assemblés par contact, des torons de ligne (3) sont décalés en ligne avec les torons de ligne de mesure (7) respectivement de la longueur de contact (11) du point de soudage (10).

5. Câble d'essai selon au moins l'une quelconque des revendications 1 à 4, **caractérisé en ce que** le toron de ligne de mesure (7) est conçu en diamètre identique ou plus petit que les torons de ligne (3) du câble intermédiaire (2) et présente de préférence au maximum une épaisseur de diamètre de toron de 2/3 du toron de ligne (3).

6. Câble d'essai selon au moins l'une quelconque des revendications 1 à 5, **caractérisé en ce que** les torons de ligne (3) respectivement regroupés et isolés du câble intermédiaire (2) et également les torons de ligne de mesure (7) regroupés sont maintenus ensemble respectivement par un flexible en tissu ou une gaine thermo-rétractable (15).

7. Câble d'essai selon au moins l'une quelconque des revendications 1 à 6, **caractérisé en ce que** les extrémités libres des torons de ligne (3) du câble intermédiaire (2) de même que celles des lignes de toron de mesure (7) sont fixées avec des assemblages sertis (13) pour former les contacts.

8. Câble d'essai selon au-moins l'une quelconque des revendications 1 à 7, **caractérisé en ce que** les extrémités du flexible en tissu (15) respectif sont fixées avec une bande adhésive (16) ou un morceau de gaine thermo-rétractable sur les torons (3, 7) regroupés.
